# EUROPEAN PATENT APPLICATION

(11) **EP 4 672 297 A1**
(43) Date of publication of application: **31.12.2025**
(21) Application number: 24184756.5
(22) Date of filing: 26.06.2024
(51) Int. Cl.: H01J 37/12, H01J 37/153, H01J 37/28

(54) **ELECTROSTATIC LENS**

(71) Applicant: ASML Netherlands B.V., 5500 AH Veldhoven (NL)
(72) Inventor: TOONEN, Wiebe Floris, 5500 AH Veldhoven (NL); KRECINIC, Faruk, 5500 AH Veldhoven (NL); WIELAND, Marco Jan-Jaco, 5500 AH Veldhoven (NL)
(74) Representative: ASML Netherlands B.V.

(57) **Abstract**

An electrostatic lens for a charged particle-optical device comprises: an upbeam charged particle-optical element in which are defined a plurality of upbeam apertures for respective beams of a plurality of beams of charged particles; a macroscopic charged particle-optical element in which is defined a macroscopic aperture for the plurality of beams; and a downbeam charged particle-optical element in which are defined a plurality of downbeam apertures for respective beams of the plurality of beams; wherein the macroscopic charged particle-optical element is located between the upbeam charged particle-optical element and the downbeam charged particle-optical element.

## Description

### FIELD

The present invention relates to an electrostatic lens, a charged particle-optical device, a method of manufacturing an electrostatic lens and a method of collimating a plurality of beams.

### BACKGROUND

During manufacturing processes of, for example, semiconductor integrated circuit (IC) chips or displays, undesired defects may occur on a substrate (e.g. wafer or a mask). Such defects may reduce yield. Defects may occur as a consequence of all kinds of processing necessary to produce an integrated circuit or display, for example, lithography, etching, deposition or chemical mechanical polishing. Defects may include patterning defects, in which the created pattern lies outside the pattern tolerance for the process, and particles. Monitoring the extent of defects during the manufacturing processes is therefore important. Such monitoring (or more generally assessment) includes the determination of the existence of a defect, but also the classification of the types of defects found.

For the assessment of a sample, different types of inspection or metrology systems have been used, including charged particle systems such as electron microscopes. Such assessment for inspection may relates to defects, for example the existence and classification of such defects. Electron microscopes typically generate a probe beam (also often referred to as primary beam) which may, for example, be scanned across a part of the substrate (such as in a scanning electron microscopes (SEM)). Collecting interaction products that result from the interaction of the primary beam with the part of the substrate, allows the electron microscope to collect data representing the probed part of the substrate. The data may be processed/rendered for example by the electron microscope to generate an image representation of the part of the substrate. The collected data for example as a generated image representation allows for measuring structures on the part of the substrate, or allows for identifying defective structures by comparing the image representation with a reference. Such measurement may be referred to as metrology; the identification of defective structures may be referred to as (defect) inspection. The interaction products may contain charged particles which may be referred to as signal particles (e.g. signal electrons), such as secondary electrons and backscattered electrons, and may contain other interaction products, such as X-ray radiation and even light.

A multi-beam system directs a plurality of primary beams to be scanned across a part of the substrate. The primary beams may diverge from each other, for example if the primary beams are derived from a divergent source beam. It may be desirable to change the angle by which the primary beams diverge from each other. For example, it may be desirable to collimate the primary beams, that is operate on the primary beams such that they are parallel to each other.

### SUMMARY

It is an aim to provide an apparatus that can adjust the divergence of primary beams that is more compact and/or less sensitive to vibrations and/or easier to manufacture and/or causes reduced aberrations in the primary beams.

According to the present invention there is provided an electrostatic lens for a charged particle-optical device comprising: an upbeam charged particle-optical element in which are defined a plurality of upbeam apertures for respective beams of a plurality of beams of charged particles; a macroscopic charged particle-optical element in which is defined a macroscopic aperture for the plurality of beams; and a downbeam charged particle-optical element in which are defined a plurality of downbeam apertures for respective beams of the plurality of beams; wherein the macroscopic charged particle-optical element is located between the upbeam charged particle-optical element and the downbeam charged particle-optical element.

According to the present invention there is provided a method of manufacturing an electrostatic lens for a charged particle-optical device, the method comprising: forming in an upbeam charged particle-optical element a plurality of upbeam apertures for respective beams of the plurality of beams; securing the upbeam charged particle-optical element to a macroscopic charged particle-optical element in which is defined a macroscopic aperture for the plurality of beams; forming in a downbeam charged particle-optical element a plurality of downbeam apertures for respective beams of the plurality of beams; and securing the downbeam charged particle-optical element to the macroscopic charged particle-optical element, such that the macroscopic charged particle-optical element is located between the upbeam charged particle-optical element and the downbeam charged particle-optical element.

According to the present invention there is provided a method of collimating a plurality of beams of charged particles with an electrostatic lens, the method comprising: applying a potential difference between an upbeam charged particle-optical element, of the electrostatic lens, in which are defined a plurality of upbeam apertures for respective beams of the plurality of beams and a macroscopic charged particle-optical element, of the electrostatic lens, in which is defined a macroscopic aperture for the plurality of beams; and applying a potential difference between the macroscopic charged particle-optical element and a downbeam charged particle-optical element, of the electrostatic lens, in which are defined a plurality of downbeam apertures for respective beams of the plurality of beams; wherein the macroscopic charged particle-optical element is located between the upbeam charged particle-optical element and the downbeam charged particle-optical element.

### BRIEF DESCRIPTION OF THE DRAWINGS

Embodiments of the invention will now be described, by way of example only, with reference to the accompanying schematic drawings, in which:
- Figure 1 is a schematic diagram of an exemplary assessment apparatus;
- Figure 2 schematically depicts a multi-beam charged particle-optical device, for example of the assessment apparatus of Figure 1;
- Figure 3 schematically depicts a charged particle-optical device array;
- Figure 4 schematically depicts a multi-beam charged particle-optical device, for example of the assessment apparatus of Figure 1;
- Figure 5 schematically depicts an alternative multi-beam charged particle-optical device, for example of the assessment apparatus of Figure 1;
- Figure 6 schematically depicts an alternative multi-beam charged particle-optical device, for example of the assessment apparatus of Figure 1;
- Figure 7 schematically depicts an alternative multi-beam charged particle-optical device, for example of the assessment apparatus of Figure 1;
- Figure 8 schematically depicts an electrostatic lens, for example of the multi-beam charged particle-optical device of Figure 4, Figure 5, Figure 6 or Figure 7;
- Figure 9 schematically depicts an alternative electrostatic lens, for example of the multi-beam charged particle-optical device of Figure 4, Figure 5, Figure 6 or Figure 7;
- Figure 10 schematically depicts part of the electrostatic lens of Figure 9;
- Figure 11 schematically depicts a plan view of a macroscopic electron-optical element, for example of the electrostatic lens of Figure 8 or Figure 9;
- Figure 12 schematically depicts a plan view of an alternative macroscopic electron-optical element, for example of the electrostatic lens of Figure 8 or Figure 9; and
- Figure 13 schematically depicts a plan view of an alternative macroscopic electron-optical element, for example of the electrostatic lens of Figure 8 or Figure 9.

The Figures are schematic. Within the following description of drawings, the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred to with reference to electrons, throughout the present document may therefore be more generally be considered to be references to charged particles, and items referred to in reference to charged particles, with the charged particles not necessarily being electrons. For example, references to an electron-optical device may more generally be considered to be references to a charged particle-optical device.

### DETAILED DESCRIPTION

There is a trend in the semiconductor industry (often known as "Moore's law") to reduce the physical dimensions of structures representing circuit components on a substrate and/or to increase the packing density of such structures, in order to reduce the physical size of electronic devices and/or enhance the computing power of electronic devices. The physical dimensions of such structures may be reduced and/or the packing density of such structures may be increased by increasing lithographic resolution. Manufacturing processes of semiconductor IC chips can have 100s of individual steps. An error in any step of the manufacturing process has the potential to adversely affect the functioning of the electronic device. It is desirable to improve the overall yield of the manufacturing process. For example, to obtain a 75% yield for a 50-step manufacturing process (where a step may indicate the number of layers formed on a substrate), each individual step must have a yield greater than 99.4%. If an individual step has a yield of 95%, the overall yield of the manufacturing process would be as low as 7-8%. It is desirable to determine defects quickly so as to maintain a high substrate throughput, defined as the number of substrates processed per hour.

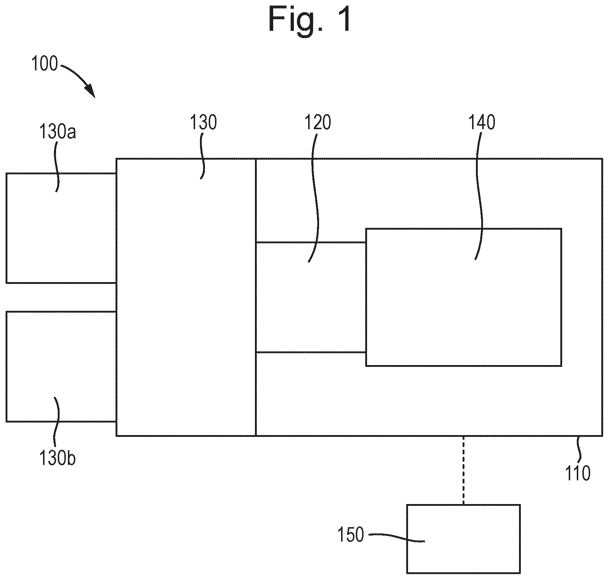

Figure 1 is a schematic diagram illustrating an exemplary assessment apparatus 100, e.g. a metrology apparatus or an inspection apparatus. The assessment apparatus 100 may be configured to scan a sample with one or more beams of electrons. The sample may be a semiconductor substrate, a substrate made of other material, or a mask, for example. The electrons interact with the sample and generate interaction products. The interaction products comprise signal electrons, e.g. secondary electrons and/or backscattered electrons, and possibly X-ray radiation. The assessment apparatus 100 may be configured to detect the interaction products from the sample so that a data set may be generated which may be processable into an image or any other data representation of the scanned area of the sample can be generated. For clarity, the description below focuses on embodiments in which the interaction products that are detected are signal electrons. The assessment apparatus 100 may comprise, for example during operation, a single beam or a plurality of beams, i.e. a multi-beam. The component beams of a multi-beam may be referred to as sub-beams or beamlets. A multi-beam may be used to scan different parts of a sample simultaneously. When the assessment apparatus 100 uses a multi-beam, the assessment apparatus 100 may assess a sample more quickly than when the assessment apparatus 100 uses a single-beam. For example, a higher throughput of sample assessment may be achieved using a multibeam assessment apparatus than a single beam apparatus.

The assessment apparatus 100 of Figure 1 comprises a vacuum chamber 110, a load lock chamber 120, an electron-optical apparatus 140, an equipment front end module (EFEM) 130 and a controller 150. The electron-optical apparatus 140 (also known as an electron beam apparatus or an electron apparatus) may be within the vacuum chamber 110. The electron-optical apparatus 140 may comprise an electron-optical device (described in more detail below) and an actuatable stage. It should be appreciated that reference in the description to the electron-optical elements of the electron-optical apparatus 140 can be considered to be a reference to the electron-optical device.

The EFEM 130 includes a first loading port 130a and a second loading port 130b. The EFEM 130 may include additional loading port(s). The first loading port 130a and the second loading port 130b may, for example, receive substrate front opening unified pods that contain samples. One or more robot arms (not shown) in the EFEM 130 transport the samples to the load lock chamber 120.

The load lock chamber 120 is used to remove the gas around a sample. The load lock chamber 120 may be connected to a load lock vacuum pump system (not shown), which removes gas particles in the load lock chamber 120. The operation of the load lock vacuum pump system enables the load lock chamber to reach a first pressure below the atmospheric pressure. The vacuum chamber 110, which may be a main chamber of the assessment apparatus 100, is connected to a main chamber vacuum pump system (not shown). The main chamber vacuum pump system removes gas molecules from the vacuum chamber 110 so that the pressure around the sample reaches a second pressure equal to or lower than the first pressure. Different parts of the electron-optical apparatus 140 may have different levels of pressure below the atmospheric pressure. After reaching the required pressure, the sample leaves the load lock chamber 120 and is transported to the electron-optical apparatus 140 by which it may be assessed. The electron-optical apparatus 140 may use either a single beam or a multi-beam for the assessment. Alternatively, an electron-optical device array comprising a plurality of electron-optical devices may be used, further also referred to as a multi-column electron-array, in which each electron-optical device (or each column in the multi-column array) comprises, for example during operation, either a single beam or a multi-beam.

The controller 150 is electronically connected to the electron-optical apparatus 140. The controller 150 may be a processor (such as a computer) configured to control the assessment apparatus 100. The controller 150 may also include processing circuitry configured to execute data, signal and image processing functions for example on the data set e.g. embodied as signals such as detection signals. The controller 150 may thus include processing circuitry configured to execute processing functions on signal, image and other data produced in the assessment apparatus 100. While the controller 150 is shown in Figure 1 as being outside of the structure that includes the vacuum chamber 110, the load lock chamber 120, and the EFEM 130, it is appreciated that the controller 150 may be part of the structure. The controller 150 may be located in one of the components of the assessment apparatus 100 or it may be distributed over at least two of the components.

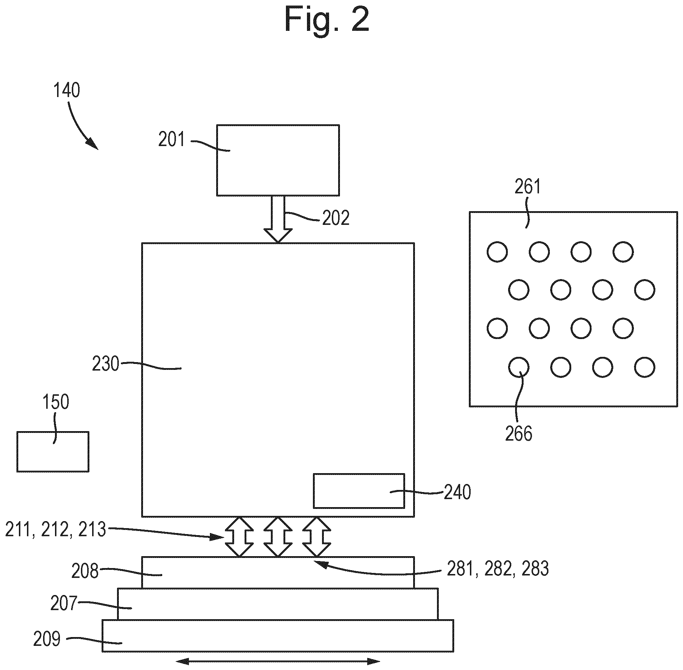

Figure 2 is a schematic diagram illustrating an exemplary electron-optical apparatus 140. The electron-optical apparatus 140 may be provided as part of the assessment apparatus 100 of Figure 1. The electron-optical apparatus 140 includes a source 201 and an electron-optical device 230 (which may also be referred to as an electron-optical column). The source 201 may comprise a cathode (not shown) and an extractor and/or anode (not shown). During operation, the source 201 is configured to emit electrons from the cathode. The electrons may be extracted or accelerated by the extractor and/or the anode to form the source beam 202.

The electron-optical device 230 may be configured to convert the source beam 202 into a plurality of primary beams 211, 212, 213 (which may be referred to as sub-beams or beamlets). The electron-optical device 230 may be configured to direct the primary beams 211, 212, 213 along respective beam paths toward a sample location for the sample 208. Although three beams are illustrated, the number of beams may be of the order of 100s, 1,000s, 10,000s, for example up to 100,000 per electron-optical apparatus 140. The plurality of beams may be referred to collectively as a multi-beam or a beam grid. The different beams may be arranged relative to each other across the beam grid in a pattern. The pattern of the beam grid may be referred to array. The electron-optical device 230 has a field of view which may be defined as the area of the surface of the sample 208 within which the primary beams 211, 212, 213 can scan while the aberrations of the electron-optical device 230 remain within a defined value. Alternatively, the field of view may be defined by the maximum scan range of the electron-optical device 230. The field of view may be of the order of millimeters, for example up to 20mm at the sample 208.

The electron-optical device 230 comprises a plurality of electron-optical elements positioned along the beam paths. The electron-optical elements are configured to manipulate the beams. For example, the electron-optical elements may be configured to lens, focus, deflect or correct the beams. The electron-optical elements may be arranged in at least one stack of electron-optical elements. Such an electron-optical element may be positioned upbeam or downbeam with respect to another of the electron-optical elements. The terms upbeam and downbeam relate to the direction of the beams from the source 201 to the sample 208 during use of the electron-optical device 230, which may be expressed as a direction along one or more of the beam paths. In an embodiment some of the different electron-optical elements may take a planar form, such as a plate 261. An electric field that manipulates the beams may be generated between two plates 261, e.g. by applying, in use, different potentials to neighboring/adjoining plates 261 such as along the beam path. An electric field that manipulates the beams may be generated between surfaces of plates 261 across the beam path for example between the neighboring plates 261. One or more beam apertures 266 may be defined in the plates 261 for the passage of one or more beams. The beam apertures 266 may be arranged in a pattern such as a regular grid e.g. hexagonal or square. Such a pattern of the beam apertures 266 may be referred to as an aperture array (i.e. a two-dimensional array over the surface of the plate). The pattern of the beam apertures 266 may correspond to the pattern of beams within the beam grid. Beam apertures 266 in different plates operating on the same beam(s) are typically aligned, i.e. in the correct position for the beam path (although they may have different positions in the x-y plane).

The electron-optical elements may comprise one or more corrector arrays. For example, a corrector array may be integrated into the shape, position and/or size of the beam apertures 266 of the plates 261. The disclosure of such a corrector array as described in WO 2022101072 A1 is hereby incorporated by reference. One or more corrector arrays may comprise multipole deflectors with a specific superposition of potentials applied across the individually controllable electrodes. The disclosure in WO2012165955 of an array of multipole deflectors is hereby incorporated by reference.

One or more of the electron-optical elements may comprise an aperture for the path of a plurality of the beams. For example, the aperture may be a macro aperture for all of the beams. The disclosures of a slit aperture for a collimator or corrector comprising strip electrodes in WO 2021156121 A1 and WO 2021204734 A1 are hereby incorporated by reference. One or more electron-optical elements may comprise one or more plate electrodes that are curved across the path of the beam grid for use as a lens array, a corrector array and/or a collimator array such as disclosed in European patent application 23211553.5 filed 22 November 2023, which is hereby incorporated by reference at least so far as the use and application of curved plate electrodes.

In the current embodiment, the electron-optical device 230 may form three probe spots 281, 282, 283 on the surface of the sample 208. The electron-optical device 230 may be configured to deflect the primary beams 211, 212, 213 so as to scan the probe spots 281, 282, 283 across individual scanning areas of the sample 208. In response to incidence of the primary beams 211, 212, 213 on the sample 208, signal electrons are generated from the sample 208 which may include secondary electrons and backscattered electrons. Secondary electrons typically have electron energy of at most 50 eV. Backscattered electrons typically have electron energy of more than 50 eV and less than the landing energy of the primary beams 211, 212, 213.

The electron-optical apparatus 140 comprises a sample holder 207 that supports a sample 208. The sample holder 207 supports the sample 208 for assessment. The sample holder 207 is supported by an actuatable stage 209. The electron-optical apparatus 140 further comprises a detector array 240. The detector array 240 may be part of the electron-optical device 230. The detector array 240 e.g. detects signal electrons from the sample 208. The detector array 240 generates detection signals based on detection of the signal electrons.

In an embodiment, the detector array 240 may define the surface of the electron-optical apparatus 140 facing the sample 208, e.g. the bottom surface of the electron-optical device 230. There may be more than one detector array at different positions along the paths of the primary beams 211, 212, 213.

The detector array 240 may comprise a plurality of detector elements, with at least one detector element per beam. The detector elements may, for example, be charge capture electrodes, for example metal plates, which may be configured to detect at least some of the signal electrons. Alternatively or additionally, the detector elements may comprise detection diodes configured to detect at least some of the signal electrons. Alternatively or additionally, the detector elements may comprise a scintillator material (such as YAG) configured to convert signal electrons into photons that may be subsequently detected. The detector elements may be arranged around beam apertures 266 in the bottom surface of the electron-optical device 230 to allow the primary beams 211, 212, 213 to pass towards the sample 208. Each detector element may comprise a plurality of detection segments or may constitute a single sensitive surface for each beam. The detection signal generated by a detector element may be transmitted to a processor for generation of an image. For example, the detection signal may represent a grey value or an intensity value of a pixel of an image.

The detector array 240 may send the detection signals, for example as an imaging signal or a detection signal, to the controller 150 or to a signal processing system (not shown) which may be part of the controller 150. The controller 150 or the signal processing system may be configured to generate images of the corresponding scanned areas of the sample 208. The detector array 240 may be incorporated at least partly into the electron-optical device 230. Alternatively, the detector array 240 may be separate from the electron-optical device 230. For example, the electron-optical apparatus 140 may comprise a secondary electron-optical device configured to direct secondary electrons to the detector array 240. In such an embodiment, the secondary electron-optical device comprises a beam separator (such as a Wien filter, not shown). The beam separator may separate the paths of the primary electrons towards the sample 208 from the paths of the signal electrons away from the sample 208. Note, such a beam separator may be present in a different embodiment with a detector array within the electron-optical device 230 for directing the primary electrons towards the sample and the signal particles to detector elements of the detector array.

The controller 150 (for example a control system comprising distributed controllers) may be connected to various parts (e.g. components) of the electron-optical apparatus 140 of Figure 2, such as the source 201, the detector array 240, the electron-optical device 230, and the actuatable stage 209. The controller 150 may perform various image processing functions and signal processing functions. The controller 150 may also generate various control signals to govern operations of the assessment apparatus 100.

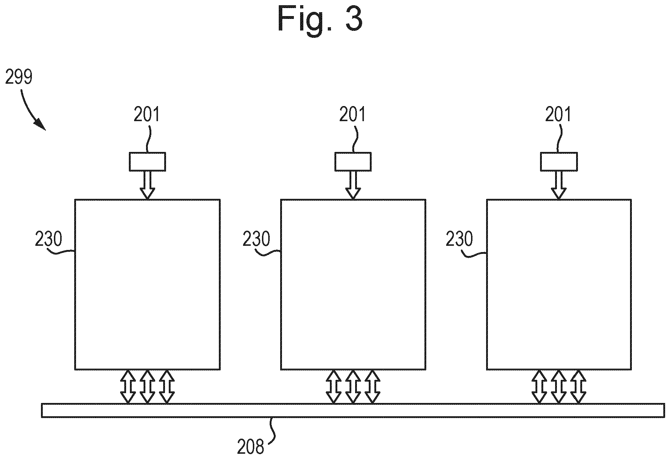

Figure 3 schematically depicts an electron-optical device array 299. In an embodiment the assessment apparatus 100 of Figure 1 comprises the electron-optical device array 299 instead of the electron-optical apparatus 140. Such an electron-optical device array 299 is also referred to as a multi-column array. The different columns (or electron-optical devices 230) may comprise in use a plurality of beams such as a beam grid. In an embodiment the electron-optical device array 299 comprises a plurality of electron-optical devices 230 of the type shown in Figure 2.

In an embodiment, one or more electron-optical elements may be shared between more than one of the electron-optical devices 230 of the electron-optical device array 299. The electron-optical elements may comprise one or more plates 261 in which a plurality of beam apertures 266 are defined for respective beam paths. In an embodiment, one or more sources 201 may be shared between more than one of the electron-optical devices 230 of the electron-optical device array 299. The sources may be comprised in a source array having different sources generating a source beam for different respective electron-optical device 230.

The electron-optical devices 230 may focus respective multi-beams simultaneously onto different regions of the same sample 208. In a different embodiment, the electron-optical devices 230 of the electron-optical device array 299 may project respective single beams towards the sample 208.

Each electron-optical device 230 of the electron-optical device array 299 may be configured in any of the ways described herein. The disclosure in WO 2022008286 A1 of how the objective lens is incorporated and adapted for use in the multi-device arrangement is hereby incorporated by reference. The disclosure in WO 2021165135 A1 of a multi-device arrangement of a multi-beam device comprising a collimator at, or proximate to, an intermediate focus is hereby incorporated by reference.

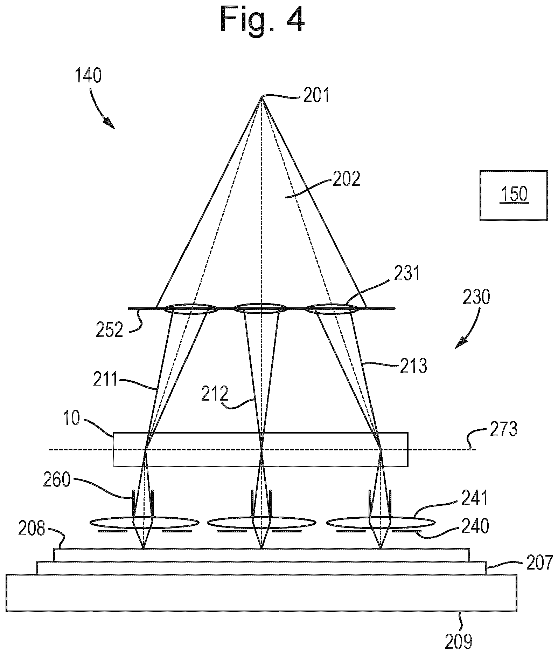

Figure 4 schematically depicts an electron-optical apparatus 140 of an assessment apparatus, e.g. the assessment apparatus 100 of Figure 1. The electron-optical apparatus 140 of Figure 4 may be the electron-optical apparatus 140 of Figure 2 in which the electron-optical elements of the electron-optical device 230 comprise a beam limiting aperture array 252, a condenser lens array 231, an electrostatic lens 10 desirably at an intermediate focus plane 273, a scan deflector array 260, an objective lens array 241 and the detector array 240.

The source 201 generates a diverging source beam 202. The beam limiting aperture array 252 defines a plurality of primary beams 211, 212, 213 from the source beam 202. The condenser lens array 231 focuses the primary beams 211, 212, 213 at the intermediate focus plane 273. The condenser lens array 231 may comprise the beam limiting aperture array 252. Alternatively, the condenser lens array 231 may be downbeam of the beam limiting aperture array 252. The condenser lens array 231 may be electrostatic. In an alternative embodiment the condenser lens array 231 comprises a magnetic element for example as a plurality of magnetic elements / one or more magnetic elements.

In an embodiment the electrostatic lens 10 is a collimator configured to (at least partially) collimate the primary beams 211, 212, 213 along respective beam paths towards and substantially orthogonal to a surface of the sample 208. The electrostatic lens 10 may be located at or near the intermediate focus plane 273. The electrostatic lens 10 may comprise a deflector configured to deflect the primary beams 211, 212, 213. The electrostatic lens 10 may comprise a stack of plates 261. In use a potential difference is applied between the plates 261 so as to generate a lensing effect at the beam apertures 266. The plates 261 may have a curvature across the beam path. The electrostatic lens 10 may comprise a macro collimator configured to collimate the primary beams 211, 212, 213.

The deflectors of the scan deflector array 260 may be formed at apertures of the scan deflector array 260. The deflectors may comprise respective sets of individually controllable electrodes. Such a deflector may be referred to as a multipole deflector. The individually controllable electrodes extend partially along the beam path of the respective beam. The individually controllable electrodes may be controlled to generate, in use, a scan movement of the respective beam across the sample 208. Typically, the sets of individually controllable electrodes operate to scan all of the primary beams 211, 212, 213 simultaneously in parallel across the individual fields of view of the respective objective lenses of the objective lens array 241. Alternatively, the scan deflector array 260 may comprise strip deflectors (as shown in WO2004081910, WO2021156121 and WO2021204734) configured to deflect a row of beams along the individual fields of view of the respective objective lenses of the objective lens array 241.

The objective lens array 241 is configured to focus the primary beams 211, 212, 213 onto the sample 208. The objective lens array 241 may comprise a stack of plates 261. Different potentials are applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The stack of plates 261 of the objective lens array 241 may be referred to as, or as part of, an objective lens assembly. The objective lens assembly may comprise one or more of the scan deflector array 260, a corrector array (not shown) and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, a condenser lens array, a collimator array, an objective lens array and a detector array are hereby incorporated by reference.

The electron-optical device 230 may comprise one or more corrector arrays configured to at least partly correct one or more types of aberration of the beams. Such corrector arrays may be associated with or integrated into the condenser lens array 231, the electrostatic lens 10 and/or the objective lens array 241, or between two of these arrays, e.g. between the condenser lens array and the collimator array.

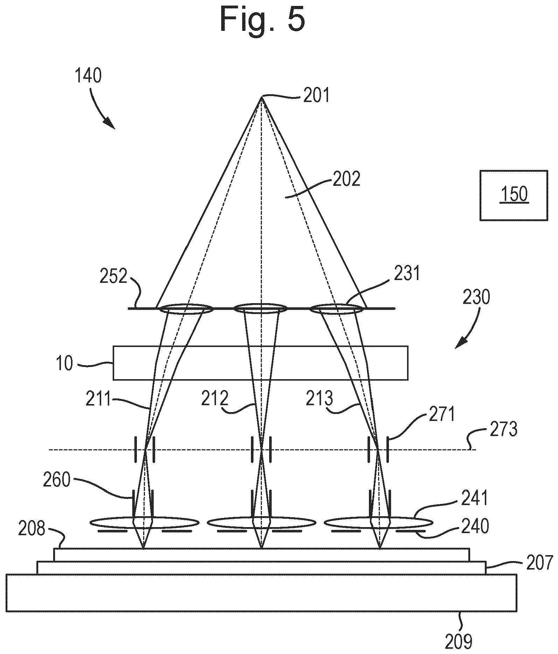

Figure 5 schematically depicts an alternative electron-optical apparatus 140 of an assessment apparatus, e.g. the assessment apparatus 100 of Figure 1. The electron-optical apparatus 140 of Figure 5 may be the electron-optical apparatus 140 of Figure 2 in which the electron-optical elements of the electron-optical device 230 comprise a beam limiting aperture array 252, a condenser lens array 231, an electrostatic lens 10, a collimator array 271 desirably at an intermediate focus plane 273, a scan deflector array 260, an objective lens array 241 and the detector array 240. The electron-optical apparatus 140 of Figure 5 may have features as described with reference to Figure 4, with the following differences.

In the electron-optical apparatus 140 of Figure 4, the electrostatic lens 10 is a collimator configured to collimate the primary beams 211, 212, 213. As shown in Figure 5, in an embodiment the electrostatic lens 10 is a pre-collimator. A pre-collimator is configured to adjust the divergence between the primary beams 211, 212, 213. The electrostatic lens 10 may be configured to reduce the divergence between the primary beams 211, 212, 213. The electrostatic lens 10 may be configured to reduce the divergence between the primary beams 211, 212, 213 to an intermediate divergence. The intermediate divergence is less than the divergence upbeam of the electrostatic lens 10 and greater than the divergence downbeam of the collimator array 271.

By reducing the angle of divergence between the primary beams 211, 212, 213, there is a greater distance in the direction along the beam paths between the condenser lens array 231 and where the array of primary beams 211, 212, 213 has reached its target dimension in the direction across the beam paths. By pre-collimating the primary beams 211, 212, 213, the required strength of collimation at the collimator array 271 may be reduced.

The collimator array 271 may comprise a plurality of deflectors configured to deflect respective primary beams 211, 212, 213. Additionally or alternatively the collimator array 271 may comprise a lens array that operates on the different beams to deflect the relative paths of the beams. The collimator array 271 may be electrostatic. The collimator array 271 may consist of a single plate 261 comprising electrodes around the beam apertures 266, such as on the surface around the beam apertures 266 and/or on the inside of the beam apertures 266. The electrodes may operate as a deflector per beam aperture 266. Alternatively, the collimator array 271 may comprise a stack of plates 261. In use a potential difference is applied between the plates 261 so as to generate a lensing effect at the beam apertures 266. The plates 261 may have a curvature across the beam path. Alternatively, the collimator array 271 may comprise a plurality of layers of strip electrode deflectors as shown in WO 2021/156121 and WO 2021/204734. A layer of strip electrode deflectors may consist of a plate. Although not shown in Figure 5, in an alternative embodiment the collimator array 271 is replaced by a macro collimator configured to collimate the primary beams 211, 212, 213. The macro collimator may be a magnetic lens, or an electrostatic lens, or a combination of magnetic and electrostatic lenses. In a further alternative embodiment, the collimator array 271 may be replaced by another electrostatic lens 10 of the same type as used as a pre-collimator.

As mentioned elsewhere, the electron-optical device 230 may comprise one or more corrector arrays configured to at least partly correct one or more types of aberration of the beams. Such corrector arrays may be associated with the collimator array 271.

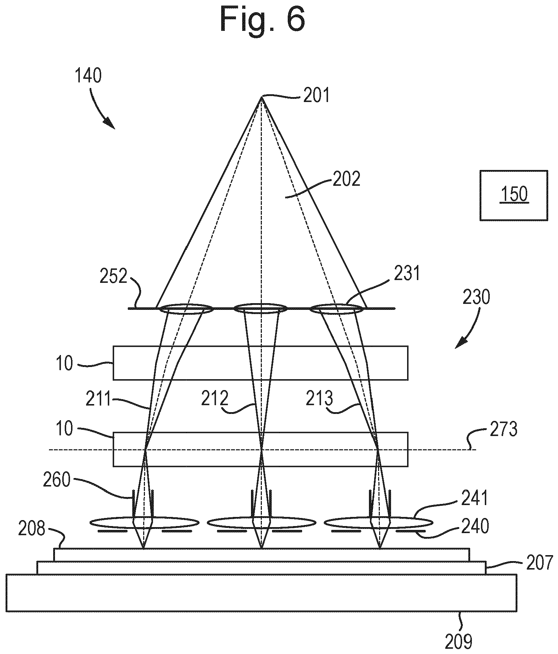

Figure 6 schematically depicts an alternative electron-optical apparatus 140 of an assessment apparatus, e.g. the assessment apparatus 100 of Figure 1. The electron-optical apparatus 140 of Figure 6 may be the electron-optical apparatus 140 of Figure 2 in which the electron-optical elements of the electron-optical device 230 comprise a beam limiting aperture array 252, a condenser lens array 231, an electrostatic lens 10, another electrostatic lens 10, desirably at an intermediate focus plane 273, a scan deflector array 260, an objective lens array 241 and the detector array 240. The electron-optical apparatus 140 of Figure 6 may have features as described with reference to Figure 4, with the following differences.

In the electron-optical apparatus 140 of Figure 4, the electrostatic lens 10 is a collimator configured to collimate the primary beams 211, 212, 213. As shown in Figure 6, in an embodiment another electrostatic lens 10 is provided as a pre-collimator. The pre-collimator is configured to adjust the divergence between the primary beams 211, 212, 213. The electrostatic lens 10 provided as a pre-collimator may be configured to reduce the divergence between the primary beams 211, 212, 213, as described with reference to Figure 5.

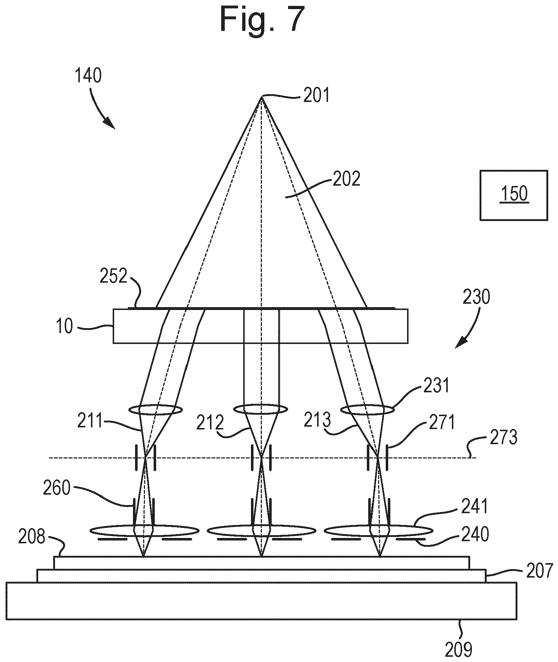

Figure 7 is a schematic view of an alternative electron-optical apparatus 140 of an assessment apparatus, e.g. the assessment apparatus 100 of Figure 1. The electron-optical apparatus 140 of Figure 7 may be the electron-optical apparatus 140 of Figure 2 in which the electron-optical elements of the electron-optical device 230 comprise an electrostatic lens, a condenser lens array 231, a collimator array 271 desirably at an intermediate focus plane 273, a scan deflector array 260, an objective lens array 241 and the detector array 240. The electron-optical apparatus 140 of Figure 7 may have features as described with reference to Figure 4, with the following differences.

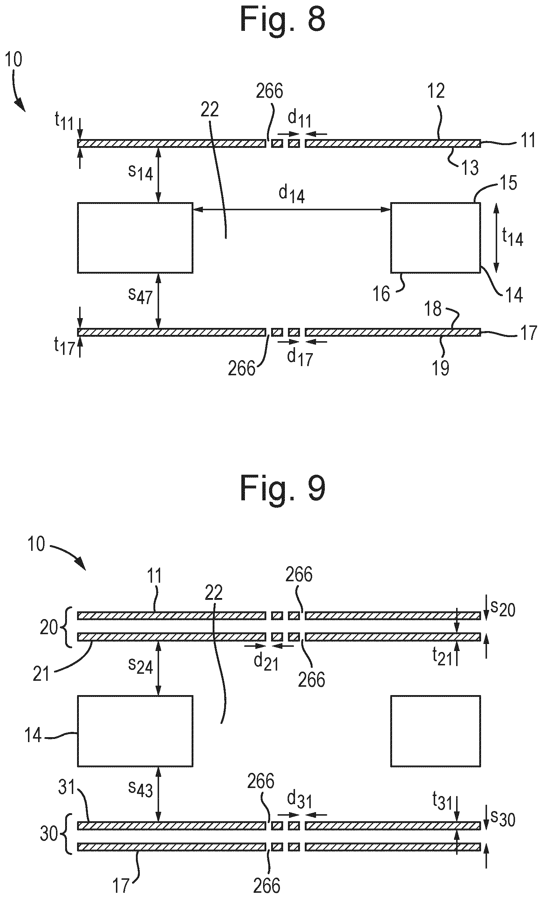

As shown in Figure 7, in an embodiment the electrostatic lens 10 is configured to derive the plurality of primary beams 211, 212, 213 from the source beam 202. The electrostatic lens 10 may perform the function of the beam limiting aperture array 252 described above. For example, the upbeam electron-optical element 11 (see Figure 8) may form the beam limiting aperture array 252, as shown in Figure 7. The upbeam apertures 266 of the upbeam electron-optical element 11 may be the apertures that limit the primary beams 211, 212, 213.

As shown in Figure 7, in an embodiment the electrostatic lens 10 is upbeam of the condenser lens array 231. The condenser lens array 231 may be located between the electrostatic lens 10 and the collimator array 271.

Figure 8 is a schematic diagram of an electrostatic lens 10, for example of the electron-optical apparatus 140 of Figure 4, Figure 5, Figure 6 or Figure 7. The electrostatic lens 10 is for a multi-beam electron-optical device 230, i.e. an electron-optical device 230 configured to direct a plurality of primary beams 211, 212, 213 along beam paths towards a sample location. The electrostatic lens 10 is configured to operate on the plurality of primary beams 211, 212, 213. As shown in Figure 4 or Figure 5, the electrostatic lens 10 may be located downbeam of where the primary beams 211, 212, 213 are derived. Alternatively as shown in Figure 7, the electrostatic lens 10 may be configured to create the primary beams 211, 212, 213.

As shown in Figure 8, in an embodiment the electrostatic lens 10 comprises a macroscopic electron-optical element 14. A macroscopic aperture 22 is defined in the macroscopic electron-optical element 14. The macroscopic aperture 22 is for passage of the plurality of primary beams 211, 212, 213. The primary beams 211, 212, 213 pass through the same macroscopic aperture 22.

In an embodiment the macroscopic electron-optical element 14 is configured to operate on the plurality of primary beams 211, 212, 213 together (to operate on the envelope of the plurality of primary beams). The macroscopic electron-optical element 14 is configured to macroscopically operate on the array of primary beams.

In use of the electrostatic lens 10, an electric potential is applied to the macroscopic electron-optical element 14. For example, the macroscopic electron-optical element 14 may be electrically connected to a power source. The controller 150 may be configured to control application of the electric potential to the macroscopic electron-optical element 14.

As shown in Figure 8, in an embodiment the electrostatic lens 10 comprises an upbeam electron-optical element 11. The upbeam electron-optical element 11 is, in use, located upbeam of the macroscopic electron-optical element 14. As shown in Figure 8, a plurality of upbeam apertures 266 are defined in the upbeam electron-optical element 11. The upbeam apertures 266 are for respective beams of the plurality of primary beams 211, 212, 213. For example, each primary beam may pass through a different aperture 266. Alternatively, each aperture 266 may be for the passage of a group of the primary beams. Different groups of primary beams may pass through different apertures 266. As a further alternative, the upbeam apertures 266 may form the primary beams 211, 212, 213.

As shown in Figure 8, in an embodiment the electrostatic lens 10 comprises a downbeam electron-optical element 17. As shown in Figure 8, a plurality of downbeam apertures 266 are defined in the downbeam electron-optical element 17. The downbeam electron-optical element 17 is located downbeam of the macroscopic electron-optical element 14. The downbeam apertures 266 are for the passage of respective beams of the plurality of primary beams 211, 212, 213. For example, the primary beams may each pass through a respective aperture 266. Alternatively, the different apertures 266 may be for the passage of different groups of the primary beams.

As shown in Figure 8, the macroscopic electron-optical element 14 is located between the upbeam electron-optical element 11 and the downbeam electron-optical element 17.

The upbeam electron-optical element 11, the macroscopic electron-optical element 14 and the downbeam electron-optical element 17 combine to form the electrostatic lens 10. For example, the upbeam electron-optical element 11, the macroscopic electron-optical element 14 and the downbeam electron-optical element 17 may be stacked relative to each other. The upbeam electron-optical element 11, the macroscopic electron-optical element 14 and the downbeam electron-optical element 17 may be secured relative to each other.

The electrostatic lens 10 may be manufactured separately from other components of the electron-optical device 230. For example, the electrostatic lens 10 may be manufactured before the electrostatic lens 10 is incorporated into an electron-optical device 230. In an embodiment the electrostatic lens 10 is field replaceable.

In an embodiment the electrostatic lens 10 is configured to control the extent by which the primary beams 211, 212, 213 diverge from each other. For example, the primary beams may be derived from a divergent source beam such that the primary beams are divergent. The electrostatic lens 10 may be configured to reduce divergence of the primary beams, for example by collimating the primary beams or pre-collimating the primary beams. Alternatively, the electrostatic lens 10 may be configured to converge the primary beams to a focus.

It is possible to provide a magnetostatic lens that is configured to control divergence among the primary beams. An embodiment of the electrostatic lens 10 is expected to be smaller than such a magnetostatic lens in the direction along the beam paths. An embodiment of the invention is expected to achieve a more compact lens. An embodiment of the invention is expected to achieve a more compact electron-optical device 230. An embodiment of the invention is expected to allow more space within the electron-optical device 230 for other electron-optical components.

An embodiment of the electrostatic lens 10 is expected to be smaller than such a magnetostatic lens in the direction across the beam paths. An embodiment of the invention is expected to achieve a more compact lens. An embodiment of the invention is expected to achieve a more compact electron-optical device 230 in the direction across the beam paths. By reducing the size in the direction across the beam paths, a plurality of electron-optical devices 230 may be located more closely to each other. An embodiment of the invention is expected to achieve a more compact electron-optical device array 299 (see Figure 3).

It is possible to provide slit deflectors that can control the divergence of the primary beams. An embodiment of the electrostatic lens 10 is expected to be less sensitive to vibrations than slit deflectors. An embodiment of the invention is expected to reduce manufacturing difficulty. An embodiment of the invention is expected to make it easier to maintain the electric fields required for collimation (or other adjustment of the divergence).

It is possible to provide slit deflectors with additional struts so as to improve the stability of the slit deflectors with respect to vibrations. Such struts can reduce the number of primary beams possible per unit area across the beam paths. An embodiment of the invention is expected to increase the number of possible primary beams per unit area. An embodiment of the invention is expected to increase throughput.

It is possible to provide an assembly consisting of several electrodes made by MEMS techniques to control the divergence along the primary beams. Such electrodes are required to be bent into the desired shape. An embodiment of the electrostatic lens 10 is expected to be easier to manufacture. An embodiment of the invention is expected to be less sensitive to alignment errors among the electron-optical elements.

It is possible to provide an electrostatic lens consisting of three macroscopic electron-optical elements stacked together to control the divergence among the primary beams. An embodiment of the invention is expected to reduce leakage of electric field outside of the electrostatic lens. By providing the macroscopic electron-optical element 14 between the upbeam electron-optical element 11 and the downbeam electron-optical element 17, the region within the electrostatic lens 10 is less open to the environment external to the electrostatic lens 10. The upbeam electron-optical element 11 and the downbeam electron-optical element 17 are more closed, compared to another macroscopic electron-optical element with a macroscopic aperture.

In an embodiment, the electrostatic lens 10 has substantially the same beam energy at the upbeam electron-optical element 11 and the downbeam electron-optical element 17. The electrostatic lens 10 may be referred to as an einzel lens. The beam energy refers to the energy of the electrons of the primary beams 211, 212, 213. The electrostatic lens 10 may be configured to substantially maintain the energy of the electrons of the primary beams 211, 212, 213 that pass through the electrostatic lens 10. The energy of the primary beams may be adjusted as the primary beams pass through the electrostatic lens 10. However, the primary beams have substantially the same energy as they exit the downbeam end of the electrostatic lens 10 as when the primary beams enter the upbeam end of the electrostatic lens 10.

In an embodiment, the controller 150 is configured to apply substantially the same electric potential to the upbeam electron-optical element 11 and the downbeam electron-optical element 17. In an embodiment the controller 150 is configured to apply an electric potential to the upbeam electron-optical element 11 to match the beam energy of the primary beams upbeam of the electrostatic lens 10. In an embodiment, the electric potential applied to the upbeam electron-optical element 11 is selected such that the region immediately upbeam of the electrostatic lens 10 is substantially free from electric fields.

It is not essential for the same electric potential to be applied to the upbeam electron-optical element 11 and the downbeam electron-optical element 17. In an alternative arrangement, the controller 150 is configured to apply different electric potentials to the upbeam electron-optical element 11 and the downbeam electron-optical element 17. By applying different electric potentials, the electrostatic lens 10 may be configured to adjust the beam energy of the primary beams.

In an embodiment, the upbeam electron-optical element 11 comprises a plate 261 (see Figure 2). In an embodiment the downbeam electron-optical element 17 comprises a plate 261. As shown in Figure 8, the upbeam electron-optical element 11 has a thickness t₁₁. The thickness t₁₁ is in the direction along the beam paths. The macroscopic electron-optical element 14 has a thickness t₁₄. The downbeam electron-optical element 17 has a thickness tn.

As shown in Figure 8, in an embodiment the thickness t₁₄ of the macroscopic electron-optical element 14 is greater than the thickness t₁₁ of the upbeam electron-optical element 11. In an embodiment the thickness t₁₄ of the macroscopic electron-optical element 14 is greater than the thickness tn of the downbeam electron-optical element 17.

The upbeam electron-optical element 11 and/or the downbeam electron-optical element 17 may be thinner than macroscopic electron-optical elements of an electrostatic lens that comprises a stack of macroscopic electron-optical elements. An embodiment of the invention is expected to be smaller in the direction along the beam paths compared to an electrostatic lens consisting of a stack of macroscopic electron-optical elements. An embodiment of the invention is expected to achieve a more compact electron-optical device 230. An embodiment of the invention is expected to allow for more space within the electron-optical device 230 for other electron-optical elements.

In an embodiment the thickness t₁₄ of the macroscopic electron-optical element 14 is greater than the combined thickness (t₁₁ + t₁₇) of the upbeam electron-optical element 11 and the downbeam electron-optical element 17. In an embodiment the ratio of the thickness t₁₁ of the upbeam electron-optical element 11 to the thickness t₁₄ of the macroscopic electron-optical element 14 is at most 0.5, optionally at most 0.2, optionally at most 0.1, optionally at most 0.05 and optionally at most 0.02. In an embodiment the ratio of the thickness t₁₇ of the downbeam electron-optical element 17 to the thickness t₁₄ of the macroscopic electron-optical element 14 is at most 0.5, optionally at most 0.2, optionally at most 0.1, optionally at most 0.05 and optionally at most 0.02.

It is not essential for the upbeam electron-optical element 11 or the downbeam electron-optical element 17 to be thinner than the macroscopic electron-optical element 14. In an alternative arrangement, the thickness tn of the upbeam electron-optical element 11 and/or the thickness t₁₇ of the downbeam electron-optical element 17 is greater than or equal to the thickness t₁₄ of the macroscopic electron-optical element 14.

In an embodiment the macroscopic aperture 22 is larger than the upbeam apertures 266 and the downbeam apertures 266. In an embodiment the macroscopic aperture 22 is larger than each of the upbeam or downbeam apertures. In an embodiment the area of the macroscopic aperture 22 in a plane across the beam paths is greater than the combined area of all of the upbeam apertures 266 defined in the upbeam electron-optical element 11. In an embodiment the area of the macroscopic aperture 22 is greater than the combined area of all of the downbeam apertures 266 defined in the downbeam electron-optical element 17.

In an embodiment the ratio of the dimension d₁₄ (e.g. diameter) of the macroscopic aperture 22 in a direction across the beam paths to the dimension d₁₁ of each upbeam aperture 266 and/or the dimension d₁₇ of each of the downbeam apertures 266 is at least 2, optionally at least 5, optionally at least 10, optionally at least 20, optionally at least 50, optionally at least 100, optionally at least 200 and optionally at least 500. By providing that the upbeam and downbeam apertures 266 are relatively small, field leakage from the electrostatic lens 10 may be reduced.

The upbeam electron-optical element 11 and the downbeam electron-optical element 17 may have a lensing effect. By providing that the upbeam electron-optical element 11 and the downbeam electron-optical element 17 operate on the individual primary beams (rather than operating macroscopically on the whole array of primary beams), the lensing effect is on each individual primary beam, rather than on the array of primary beams. For example, the upbeam electron-optical element 11 may be expected to defocus each primary beam, rather than defocusing the array of primary beams. An embodiment of the invention is expected to improve focusing of the array of primary beams.

The upbeam electron-optical element 11 and the downbeam electron-optical element 17 may be expected to have a weaker lensing effect compared to a macroscopic electron-optical element. As a result, the potential difference required between the electrodes to achieve a given change in divergence among the primary beams may be reduced. An embodiment of the invention is expected to reduce power consumption.

Compared to an einzel lens consisting of three macroscopic electron-optical elements, an embodiment of the invention is expected to have improved field containment. An embodiment of the invention is expected to be associated with reduced chromatic operation. An embodiment of the invention is expected to be associated with reduced spherical aberration.

In an embodiment the upbeam apertures 266 and/or the downbeam apertures 266 are arranged in a pattern in the upbeam electron-optical element 11 and/or the downbeam electron-optical element 17. The pattern may be a regular pattern. In an embodiment the upbeam apertures 266 and/or the downbeam apertures 266 are arranged at a pitch. The pitch may be substantially constant across the electron-optical elements.

In an embodiment the pitch between the upbeam apertures 266 is different from the pitch between the downbeam apertures 266. The pattern of the upbeam apertures 266 may be substantially as the same as the pattern of the downbeam apertures 266 except for the different pitch. As a result of the difference in pitch, the upbeam apertures 266 may be misaligned from the downbeam apertures 266.

The upbeam and downbeam apertures 266 may be arranged to match the pattern of the array of primary beams 211, 212, 213. The electrostatic lens 10 may be arranged to operate on diverging primary beams. As a result of the primary beams diverging from each other, the distance, in a direction across the beam paths, between the primary beams may be smaller at the upbeam end of the electrostatic lens 10 than at the downbeam end of the electrostatic lens 10. As a result, the pitch for the upbeam apertures 266 may be smaller than the pitch for the downbeam apertures 266.

However, it is not essential for the pitch between the upbeam apertures to be different from the pitch between the downbeam apertures. In an alternative arrangement, the pitch between the upbeam apertures is substantially equal to the pitch between he downbeam apertures. For example, the electrostatic lens 10 may be located at a position where the primary beams are expected to be substantially parallel.

In an embodiment, the pitch between the upbeam apertures is greater than the pitch between the downbeam apertures. For example, the electrostatic lens 10 may be configured to operate on converging primary beams. As a result of the converging primary beams, the distance between the primary beams at the upbeam end of the electrostatic lens 10 may be greater than the distance between primary beams at the downbeam end of the electrostatic lens 10.

As shown in Figure 8, the macroscopic electron-optical element 14 may be spaced from the upbeam electron-optical element 11. There may be a spacing s₁₄ in the direction along the beam paths between the upbeam electron-optical element 11 and the macroscopic electron-optical element 14. The upbeam electron-optical element 11 may have an upbeam surface 12 and a downbeam surface 13. The macroscopic electron-optical element may have an upbeam surface 15 and a downbeam surface 16. The spacing s₁₄ is between the downbeam surface 13 of the upbeam electron-optical element 11 and the upbeam surface 15 of the macroscopic electron-optical element 14.

As shown in Figure 8, the macroscopic electron-optical element 14 may be spaced from the downbeam electron-optical element 17. The downbeam electron-optical element 17 may have an upbeam surface 18 and a downbeam surface 19. There may be a spacing s₄₇ between the macroscopic electron-optical element 14 and the downbeam electron-optical element 17. The spacing s₄₇ is between the downbeam surface 16 of the macroscopic electron-optical element 14 and the upbeam surface 18 of the downbeam electron-optical element 17.

As shown in Figure 8, in an embodiment the spacing s₁₄ in the direction along the beam paths between the upbeam electron-optical element 11 and the macroscopic electron-optical element 14 is greater than the dimension d₁₁ in the direction across the beam paths of each of the upbeam apertures 266. The ratio of the spacing s₁₄ to the dimension d₁₁ may be at least 2, optionally at least 5 and optionally at least 10. By providing a greater spacing s₁₄, the maximum magnitude of the electric field within the electrostatic lens 10 may be reduced. The possibility of electrical breakdown may be reduced.

In an embodiment the spacing s₄₇ in the direction along the beam paths between the macroscopic electron-optical element 14 and the downbeam electron-optical element 17 is greater than the dimension d₁₇ in the direction across the beam paths of each of the downbeam apertures 266. In an embodiment the ratio between the spacing s₄₇ and the dimension d₁₇ is at least 2, optionally at least 5 and optionally at least 10. By increasing the spacing s₄₇, the maximum magnitude of the electric field may be reduced. The possibility of electrical breakdown may be reduced.

In an embodiment, the dimension d₁₁ in the direction across the beam paths of each of the upbeam apertures 266 is smaller than the thickness t₁₁ in the direction along the beam paths of the upbeam electron-optical element 11. In an embodiment the dimension d₁₇ in the direction across the beam paths of each of the downbeam apertures 266 is smaller than the thickness t₁₇ in the direction along the beam paths of the downbeam electron-optical element 17. By providing that the dimensions d₁₁, d₁₇ are relatively small, field containment of the electrostatic lens 10 may be improved.

In an embodiment, the ratio of the thickness tn of the upbeam electron-optical element 11 to the dimension d₁₁ of the upbeam apertures 266 is at most 10, optionally at most 5, optionally at most 3 and optionally at most 2. In an embodiment the ratio of the thickness t₁₇ of the downbeam electron-optical element 17 to the dimension d₁₇ of the downbeam apertures 266 is at most 10, optionally at most 5, optionally at most 3, and optionally at most 2. By reducing the ratio, the electron-optical elements may be easier to manufacture. By reducing the ratio, any undesirable disturbance of the primary beams by the electron-optical elements may be reduced.

As shown in Figure 4 and Figure 5, for example, in an embodiment the electrostatic lens 10 is located downbeam of the condenser lens array 231. For example, as shown in Figure 4 the electrostatic lens 10 may be located such that the electrostatic lens 10 is substantially at the focal plane 273. In an embodiment the electrostatic lens 10 is located such that the macroscopic electron-optical element 14 is substantially at the focal plane 273. In an embodiment the electrostatic lens 10 is located such that the mid-point (in the direction along the beam paths) of the macroscopic electron-optical element 14 is substantially at the focal point 273.

However, it is not essential for the electrostatic lens 10 to be at the focal plane 273. For example, Figure 5 and Figure 7 show arrangements in which the electrostatic lens 10 is located upbeam of the focal plane 273.

Figure 9 schematically depicts an alternative electrostatic lens 10. The electrostatic lens 10 may have the same features as described with reference to Figure 8. Further optional features of the electrostatic lens 10 of Figure 9 are described below.

As shown in Figure 9, in an embodiment the electrostatic lens 10 comprises a focusing electron-optical element 21. The focusing electron-optical element 21 may be located upbeam of the macroscopic electron-optical element 14. As shown in Figure 9, in an embodiment the upbeam electron-optical element 11 and the focusing electron-optical element 21 may form an upbeam two-electrode lens 20.

The focusing electron-optical element 21 may comprise a plate in which beam apertures 266 are defined. The focusing electron-optical element 21 may have a thickness t₂₁ in the direction along the beam paths. The thickness t₂₁ of the focusing electron-optical element 21 may be greater than the dimension d₂₁ of the beam apertures 266 defined in the focusing electron-optical element 21.

As shown in Figure 9, in an embodiment the beam apertures 266 defined in the focusing electron-optical element 21 are aligned with the beam apertures 266 defined in the upbeam electron-optical element 11.

As shown in Figure 9, in an embodiment the electrostatic lens 10 comprises a conjugate electron-optical element 31. As shown in Figure 9, in an embodiment the conjugate electron-optical element 31 and the downbeam electron-optical element 17 form a downbeam two-electrode lens 30. As shown in Figure 9, the conjugate electron-optical element 31 may have a thickness t₃₁ in the direction along the beam paths. The conjugate electron-optical element 31 may comprise a plate in which are defined beam apertures 266. The beam apertures 266 may have a dimension d₃₁ in the direction across the beam paths. In an embodiment the thickness t₃₁ of the conjugate electron-optical element 31 is greater than the dimension d₃₁ of the beam apertures 266 defined in the conjugate electron-optical element 31.

As shown in Figure 9, in an embodiment the beam apertures 266 defined in the conjugate electron-optical element 31 are aligned with the beam apertures 266 defined in the downbeam electron-optical element 17.

As shown in Figure 9, in an embodiment the electrostatic lens 10 comprises upbeam and downbeam electrodes that constitute two-electrode lenses. In an embodiment the upbeam two-electrode lens 20 and the downbeam two-electrode lens 30 are configured to reduce the effect of aperture fields on the alignment of the primary beams 211, 212, 213. The apertures fields are fields within the beam apertures 266 defined in the upbeam electron-optical element 11 and the downbeam electron-optical element 17. It is possible for these beam apertures 266 to have a lensing effect on the primary beams 211, 212, 213. Such a lensing effect can result in an angular error. Such an angular error can cause a deterioration of the performance of the system. For example, the cross-sectional area of the primary beams 211, 213 that are off-axis may increase at the location at which the primary beams 211, 213 enter the objective lens array 234. As another example, any angular error can result in a loss of primary beams that can collide with electrodes within the electron-optical device 230.

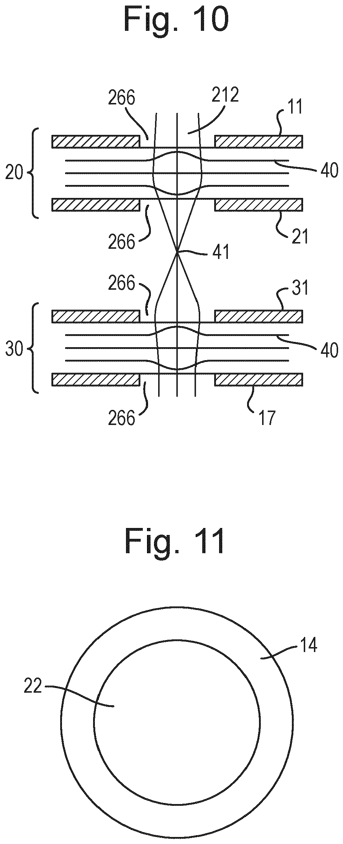

Figure 10 is a schematic view of the operation of the upbeam two-electrode lens 20 and the downbeam two-electrode lens 30 on one of the primary beams 212. Figure 10 shows a primary beam 212 which is on-axis, for convenience of explanation. The macroscopic electron-optical element 14 is not shown in Figure 10.

As shown in Figure 10, in an embodiment the focusing electron-optical element 21 is arranged such that an electric field 40 between the upbeam electron-optical element 11 and the focusing electron-optical element 21 focusses each of the plurality of primary beams 211, 212, 213 to a respective focus 41. The focus 41 is between the upbeam electron-optical element 11 and the downbeam electron-optical element 17. The upbeam two-electrode lens 20 has a focal length. In an embodiment the controller 150 is configured to control application of electric potentials to the upbeam electron-optical element 11 and the focusing electron-optical element 21 dependent on a target focal length of the upbeam two-electrode lens 20. The controller 150 may be configured to tune the focal length of the upbeam two-electrode lens 20.

As shown in Figure 10, in an embodiment the focus 41 is substantially halfway in a direction along the beam paths between the upbeam electron-optical element 11 and the downbeam electron optical element 17. The focal length of the upbeam two-electrode lens 20 may be tuned such that it is equal to half of the distance between the upbeam two-electrode lens 20 and the downbeam two-electrode lens 30. However, it is not essential for the focus 41 to be halfway between the upbeam electron-optical element 11 and the downbeam electron optical element 17, particularly when the lensing effect of the upbeam two-electrode lens 20 is different from the lensing effect of the downbeam two-electrode lens 30.

As shown in Figure 9, in an embodiment the upbeam electron-optical element 11 is spaced from the focusing electron-optical element 21 by a spacing s20 in the direction along the beam paths. The upbeam two-electrode lens 20 may be spaced from the macroscopic electron-optical element 14 by a spacing s24 in the direction along the beam paths. In the arrangement shown in Figure 9, the focusing electron-optical element 21 is downbeam of the upbeam electron-optical element 11. The spacing s24 is between the macroscopic electron-optical element 14 and the focusing electron-optical element 21.

As shown in Figure 9, in an embodiment the spacing s20 is smaller than the spacing s24. In an embodiment the potential difference between the macroscopic electron-optical element 14 and the upbeam electron-optical element 11 is greater than the potential difference between the focusing electron-optical element 21 and the upbeam electron-optical element 11. As shown in Figure 9, most of the space within the electrostatic lens 10 is used for the electric field that performs the collimating action of the electrostatic lens 10 rather than for the electric field 40 within the upbeam two-electrode lens 20.

As shown in Figure 9, in an embodiment the focusing electron-optical element 21 is located between the upbeam electron-optical element 11 and the macroscopic electron-optical element 14. In an alternative arrangement, the focusing electron-optical element 21 may be located upbeam of the upbeam electron-optical element 11.

As shown in Figure 10, in an embodiment the conjugate electron-optical element 31 is arranged such that an electric field 40 between the conjugate electron-optical element 31 and the downbeam electron-optical element 17 operates on each of the plurality of primary beams 211, 212, 213 with a focal length less than the axial distance along the beam paths between the upbeam electron-optical element 11 and the downbeam electron-optical element. The downbeam two-electrode lens 30 has a focal length.

In an embodiment the controller 150 is configured to control the application of electric potentials to the conjugate electron-optical element 31 and the downbeam electron-optical element 17 so as to control the focal length of the downbeam two-electrode lens 30. The focal length of the downbeam two-electrode lens 30 may be tuned.

As shown in Figure 10, in an embodiment the focal length of the downbeam two-electrode lens 30 is substantially half the axial distance between the upbeam electron-optical element 11 and the downbeam electron-optical element 17. As shown in Figure 10, in an embodiment the focal length of the upbeam two-electrode lens 20 is substantially equal to the focal length of the downbeam two-electrode lens 30.

By tuning the focal length of the upbeam two-electrode lens 20 and the downbeam two-electrode lens 30 such that they are equal to each other and equal to half of the distance between them, a displacement at the upbeam end of the electrostatic lens 10 results in only a displacement of the primary beam 212 at the downbeam end of the electrostatic lens 10. There may be substantially no resulting angular error. An embodiment of the invention is expected to reduce angular error of the primary beams 211, 212, 213. An embodiment of the invention is expected to increase consistency of spot sizes of the primary beams 211, 213 that reach the objective lens array 234. An embodiment of the invention is expected to reduce any loss of primary beams 211, 212, 213 as a result of colliding with electrodes within the electron-optical device 230.

As shown in Figure 9, in an embodiment the conjugate electron-optical element 31 is located between the macroscopic electron-optical element 14 and the downbeam electron-optical element 17. However, in an alternative arrangement, the downbeam electron-optical element 17 is located between the conjugate electron-optical element 31 and the macroscopic electron-optical element 14.

As shown in Figure 9, the conjugate electron-optical element 31 may be spaced from the downbeam electron-optical element 17 by a spacing s₃₀ in the direction along the beam paths. The downbeam two-electrode lens 30 may be spaced from the macroscopic electron-optical element 14 by a spacing s₄₃ in the direction along the beam paths. In an embodiment the spacing s₄₃ is greater than the spacing s₃₀. This allows more space within the electrostatic lens 10 for the electric field that collimates (at least partially) the primary beams 211, 212, 213. In an embodiment the potential difference between the macroscopic electron-optical element 14 and the downbeam electron-optical element 17 is greater than the potential difference between the conjugate electron-optical element 31 and the downbeam electron-optical element 17.

It is not essential for the focusing electron-optical element 21 and the conjugate electron-optical element 31 to be provided in the same embodiment. In an alternative embodiment, the electrostatic lens 10 comprises the focusing electron-optical element 21, while the conjugate electron-optical element 31 is omitted. In a further alternative arrangement, the electrostatic lens 10 comprises the conjugate electron-optical element 31, while the focusing electron-optical element 21 is omitted. However, when both the focusing electron-optical element 21 and the conjugate electron-optical element 31 are provided, they may combine synergistically so as to reduce or eliminate angular error of the primary beams 211, 212, 213.

In an embodiment, the macroscopic electron-optical element 14 is configured to deflect the plurality of primary beams 211, 212, 213. That is, the macroscopic electron-optical element 14 is configured to operate on the envelope of the plurality of primary beams 211, 212, 213.

Figure 11 schematically depicts a plan view of the macroscopic electron-optical element 14. As shown in Figure 11, the macroscopic aperture 22 is defined by the macroscopic electron-optical element 14. As shown in Figure 11, in an embodiment the macroscopic electron-optical element 14 is unitary. That is, the macroscopic electron-optical element 14 may come in one piece. The macroscopic electron-optical element 14 may fully surround the macroscopic aperture 22.

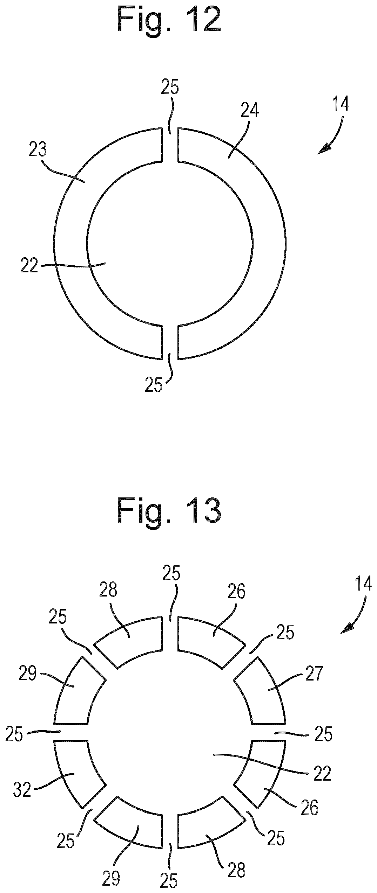

Figure 12 schematically depicts, in plan view, an alternative macroscopic electron-optical element 14. As shown in Figure 12, in an embodiment the macroscopic electron-optical element 14 comprises a plurality of segments 23, 24. The plurality of segments 23, 24 are around the beam paths of the primary beams 211, 212, 213. The macroscopic electron-optical element 14 defines the macroscopic aperture 22.

As shown in Figure 12, gaps 25 may be provided between the segments 23, 24 of the macroscopic electron-optical element 14. The segments 23, 24 may be electrically isolated from each other. In an embodiment, different electric potentials can be applied to the different segments 23, 24. The macroscopic aperture 22 may be defined by the inner edges of the segments 23, 24.

By applying different electric potentials to the different segments 23, 24, the macroscopic electron-optical element 14 is configured to deflect the plurality of primary beams 211, 212, 213. In an embodiment the controller 150 is configured to control a potential difference between the segments 23, 24 so as to control deflection by the macroscopic electron-optical element 14. The controller 150 may be configured to control application of electric potentials to the segments 23, 24 based on a target deflection by the macroscopic electron-optical element 14.

It is possible that the electrostatic lens 10 may cause an undesirable deflection of the primary beams 211, 212, 213. By configuring the macroscopic electron-optical element 14 in segments 23, 24, an additional deflection of the macroscopic beam (i.e. the envelope of primary beams) may be implemented. In an embodiment the electrostatic lens 10 is configured to impart a negligible (or no) deflection to the macroscopic beam.

As shown in Figure 12, in an embodiment the macroscopic electron-optical element 14 consists of two segments 23, 24. Figure 13 schematically depicts, in plan view, an alternative macroscopic electron-optical element 14. As shown in Figure 13, in an embodiment the macroscopic electron-optical element 14 comprises eight segments 26, 27, 28, 29, 32. In a further alternative arrangement, the macroscopic electron-optical element 14 comprises at least four segments (the embodiment shown in Figure 13 comprises eight segments). By providing that the macroscopic electron-optical element 14 comprises at least four segments, deflection by the macroscopic electron-optical element 14 may be controlled in two dimensions. Alternatively, as shown in Figure 12 the macroscopic electron-optical element 14 may control deflection in only one dimension. As shown in Figure 12, in an embodiment each segment is of substantially the same size. In the arrangement shown in Figure 12, each segment 23, 24 extends around about half of the macroscopic electron-optical element 14. Each segment 23, 24 extends around about 180 degrees of the macroscopic aperture 22.

As shown in Figure 13, in an embodiment each of the eight segments extends around about 45 degrees of the macroscopic aperture 22. In an alternative arrangement in which the macroscopic electron-optical element 14 comprises four segments, each segment may extend around about 90 degrees of the macroscopic aperture 22.

In the arrangement shown in Figure 13, different electric potentials may be applied to different segments. In an embodiment, two or more of the segments have the same electric potential applied.

In an embodiment the electric potential to be applied to the macroscopic electron-optical element 11 is selected based on the target strength of electric field within the electrostatic lens 10. The electric potential may be selected so as to provide a target potential difference relative to the upbeam electron optical element 11 and the downbeam electron-optical element 17.

Where the macroscopic electron-optical element 14 comprises a plurality of segments, a plurality of electric potentials may be applied to the segments of the macroscopic electron-optical element 14. The electric potentials may be determined based on the desired collimation (i.e. the desired potential difference relative to the upbeam electron-optical element 11 and the downbeam electron-optical element 17) and the desired deflection of the macroscopic beam. The electric potential applied to each segment may be determined from the collimation potential and the deflection potential. The deflection potential may be considered to be a correction to the collimation potential.

For example, the collimation potential may be at least 1 kV, optionally at least 2 kV, optionally at least 5 kV and optionally at least 10 kV. The collimation potential is the potential difference to the upbeam electron-optical element 11 and the downbeam electron-optical element 17. The collimation potential is for changing the divergence among the primary beams 211, 212, 213. The deflection potential may be smaller than the collimation potential. The deflection potential may be the maximum potential difference among the segments of the macroscopic electron-optical element 14. The deflection potential may be for deflecting the envelope of primary beams 211, 212, 213. The deflection potential may be at most 200 V, optionally at most 100 V, optionally at most 50 V and optionally at most 20 V to impart a deflection of one mrad to the envelope of primary beams 211, 212, 213.

In an embodiment, the electric potentials applied to the segments of the macroscopic electron-optical element 14 are an approximation of a sinusoidal function going around the macroscopic aperture 22. In the simplest example of there being two segments 23, 24 as shown in Figure 12, the electric potential applied to a first segment 23 is greater than the collimation potential, while the electric potential applied to a second segment 24 is less than the collimation potential. The average of the electric potentials applied to the segments is substantially equal to the collimation potential.

In the example shown in Figure 13, in an embodiment six different electric potentials are applied to the segments. For example, an electric potential substantially equal to the collimation potential may be applied to two of the segments 28. Three of the segments 26, 27 may have electric potentials greater than the collimation potential applied to them. Three of the segments 29, 32 may have electric potentials less than the collimation potential applied to them. The average of the electric potentials applied to the segments may be substantially equal to the collimation potential. The electric potential applied to the segment 27 may be greater than the electric potential applied to the two segments 26. Substantially the same electric potential may be applied to the two segments 26. A lower electric potential may be applied to the segment 32 than to the two segments 29. Substantially the same electric potential may be applied to the two segments 29. Five different electric potentials may be applied among the eight segments.

In an embodiment, the macroscopic electron-optical element 14 comprises more than eight segments. For example, the macroscopic electron-optical element 14 comprises at least twelve or at least sixteen segments.

In an alternative embodiment, the macroscopic electron-optical element 14 comprises four segments. The segments extend around about 120 degrees, 60 degrees, 120 degrees and 60 degrees, respectively, around the macroscopic aperture 22. The two 60 degree segments may be opposite each other, having the macroscopic aperture 22 between them. The two 60 degree segments may have an electric potential applied to them equal to the collimation potential (i.e. without any correction for deflection). One of the two 120 degree segments may have applied to it an electric potential greater than the collimation potential. The other of the two 120 degree segments may have applied to it an electric potential less than the collimation potential.

The macroscopic electron-optical element 14 may be configured as a stigmator. The macroscopic electron-optical element 14 may be configured to adjust astigmatism of the envelope of primary beams 211, 212, 213. In an embodiment the macroscopic electron-optical element 14 is configured to adjust astigmatism so as to correct for unroundness of the macroscopic electron-optical element 14. In an embodiment the macroscopic electron-optical element 14 is configured to adjust astigmatism so as to correct for unroundness of any other macroscopic electron-optical element of the electron-optical apparatus 140.

In an embodiment the electrostatic lens 10 comprises spacers. The spacers are configured to space the upbeam electron-optical element 11, the macroscopic electron-optical element 14 and the downbeam electron-optical element 17 from each other. The spacers may be configured to mechanically support the electron-optical elements relative to each other. The spacers may be configured to electrically isolate the electron-optical elements from each other. In embodiments in which further electrodes are provided (e.g. the focusing electron-optical element 21 and/or the conjugate electron-optical element 31), further spacers may be provided to space the further electron-optical elements from the upbeam electron-optical element 11, the macroscopic electron-optical element 14 and the downbeam electron-optical element 17.

In an embodiment the controller 150 is configured to control the potential difference between the macroscopic electron-optical element 14 and each of the upbeam electron-optical element 11 and the downbeam electron-optical element 17 dependent on a target change. The target change is a change of divergence between the primary beams 211, 212, 213 to be imparted by the electrostatic lens 10.

In an embodiment the controller 150 is configured to control the electric potentials applied to the upbeam electron-optical element 11 and the downbeam electron-optical element such that a beam energy of charged particles of the primary beams entering the electrostatic lens 10 is substantially equal to a beam energy of charged particle beams of the primary beams exiting the electrostatic lens 10.

In an embodiment there is provided a method of manufacturing the electrostatic lens 10. The method may comprise forming in the upbeam electron-optical element 11 the plurality of upbeam apertures 266 for respective primary beams. The method may comprise securing the upbeam electron-optical element 11 to the macroscopic electron-optical element 14. In an embodiment the upbeam apertures 266 are formed before the upbeam electron-optical element 11 is secured to the macroscopic electron-optical element 14. In an alternative arrangement, the upbeam apertures 266 are formed after the upbeam electron-optical element 11 has been secured to the macroscopic electron-optical element 14.

In an embodiment the method comprises forming the downbeam apertures 266 in the downbeam electron-optical element 17. In an embodiment the method comprises securing the downbeam electron-optical element 17 to the macroscopic electron-optical element 14. In an embodiment the downbeam apertures 266 are formed before the downbeam electron-optical element 17 is secured to the macroscopic electron-optical element 14. In an alternative arrangement, the downbeam electron-optical element 17 is secured to the macroscopic electron-optical element 14 before the downbeam apertures 266 are formed.

In an embodiment the downbeam electron-optical element 17 is secured to the macroscopic electron-optical element 17 via a spacer between the macroscopic electron-optical element 14 and the downbeam electron-optical element 17.

In an embodiment any electron-optical element or group of electron-optical elements may be replaceable or field replaceable within the electron-optical apparatus 140. For example, the electrostatic lens 10 may be field replaceable. Field replaceability means that the electron-optical element or group of electron-optical elements may be replaced without substantially disassembling the electron-optical apparatus 140. In an embodiment the electron-optical apparatus 140 comprises at least one module. Each module comprises a group of adjacent electron-optical elements. The electron-optical elements of a module may be secured to each other, for example as a stack.

Features in electron-optical plates may be manufactured using techniques from microelectromechanical systems (MEMS) (i.e. using MEMS manufacturing techniques). For example, the upbeam electron-optical element 11 and the downbeam electron-optical element 17 may be manufactured using techniques from MEMS (lithography and etching). The upbeam electron-optical element 11 and the downbeam electron-optical element 17 could be made from silicon wafers. This may facilitate making a large number of aperture 266 (e.g. from 100 to 100,000 apertures 266). This may facilitate more accurately controlling the diameter and ellipticity of the apertures 266. This may result in lenses with lower aberrations (e.g. lower astigmatism). This may also result in better control of the lens strengths (lower variation between the individual lenses).

MEMS are miniaturized mechanical and electromechanical elements that are made using microfabrication techniques. Merely as an example, a collimator array may be formed using MEMS manufacturing techniques so as to be spatially compact. As another example, a scan deflector array may be formed using MEMS manufacturing techniques.

An electric power source may be provided to supply power to the assessment apparatus 100 and/or electron-optical apparatus 140. For example, such a power supply may apply respective potentials to electrodes of lenses of the electron-optical device 230.

In an embodiment, the controller 150 is configured to control the electron-optical device 230. The controller 150 may be configured to control potentials applied to electrodes of lenses of the electron-optical device 230.

In an embodiment the controller 150 is configured to control the actuatable stage 209 to move the sample 208 during inspection of the sample 208. The controller 150 may enable the actuatable stage 209 to move the sample 208 in a direction, for example continuously, such as at a constant speed, at least during sample inspection, which may be referred to as a type of scanning. The speed of the actuatable stage 209 may be referred to as the moving rate. The controller 150 may control movement of the actuatable stage 209 so as to change the speed of movement of the sample 208 relative to the beam paths dependent on one or more parameters. The controller 150 may control deflection of scan deflectors so that the beam paths move relative to the actuatable stage 209 and thus over the surface of the sample 208. The controller 150 may change a beam deflection of a scan deflector and thus the scanning of the primary beams 211, 212, 213 over the sample 208 dependent on one or more parameters. For example, the controller 150 may control a scan deflector and/or the speed of the actuatable stage 209 and/or the direction of movement of the actuatable stage 209 depending on characteristics of the assessment process. The disclosure in EP4086933 A1 of a combined stepping and scanning strategy of the stage and scanning deflectors is hereby incorporated by reference. The moving rate may at different times comprise a stepping frequency and/or a stage scanning rate.

Although specific reference may be made in this text to embodiments of the invention in the context of an electron microscope, embodiments of the invention may be used in other types of apparatus. Embodiments of the invention may form part of a mask inspection apparatus, a metrology apparatus, or any apparatus that measures or processes an object such as a wafer (or other substrate) or mask (or other patterning device).

Although specific reference may have been made above to the use of embodiments of the invention in the context of sample assessment, it will be appreciated that the invention, where the context allows, is not limited to sample assessment and may be used in other applications, for example electron beam lithography.

Embodiments include the following numbered clauses:
Clause 1: an electrostatic lens for a charged particle-optical device comprising:
   an upbeam charged particle-optical element in which are defined a plurality of upbeam apertures for respective beams of a plurality of beams of charged particles;
   a macroscopic charged particle-optical element in which is defined a macroscopic aperture for the plurality of beams; and
   a downbeam charged particle-optical element in which are defined a plurality of downbeam apertures for respective beams of the plurality of beams;
   wherein the macroscopic charged particle-optical element is located between the upbeam charged particle-optical element and the downbeam charged particle-optical element.
Clause 2: the electrostatic lens of clause 1, configured as an einzel lens.
Clause 3: the electrostatic lens of clause 1 or 2, wherein a thickness in a direction along the beam paths of the macroscopic charged particle-optical element is greater than a thickness in the direction along the beam paths of each of the upbeam charged particle-optical element and the downbeam charged particle-optical element.
Clause 4: the electrostatic lens of any preceding clause, wherein the macroscopic aperture is larger than the upbeam apertures and the downbeam apertures.
Clause 5: the electrostatic lens of any preceding clause, wherein a pitch between the upbeam apertures is different from a pitch between the downbeam apertures.
Clause 6: the electrostatic lens of clause 5, wherein the pitch between the upbeam apertures is smaller than the pitch between the downbeam apertures.
Clause 7: the electrostatic lens of any preceding clause, wherein a spacing in a direction along the beam paths between the upbeam charged particle-optical element and the macroscopic charged particle-optical element is greater than a dimension in a direction across the beam paths of each of the upbeam apertures.
Clause 8: the electrostatic lens of any preceding clause, wherein a spacing in a direction along the beam paths between the macroscopic charged particle-optical element and the downbeam charged particle-optical element is greater than a dimension in a direction across the beam paths of each of the downbeam apertures.
Clause 9: the electrostatic lens of any preceding clause, wherein a dimension in a direction across the beam paths of each of the upbeam apertures is smaller than a thickness in a direction along the beam paths of the upbeam charged particle-optical element.
Clause 10: the electrostatic lens of any preceding clause, wherein a dimension in a direction across the beam paths of each of the downbeam apertures is smaller than a thickness in a direction along the beam paths of the downbeam charged particle-optical element.
Clause 11: the electrostatic lens of any preceding clause, wherein the macroscopic charged particle-optical element is configured to deflect the plurality of beams.
Clause 12: the electrostatic lens of clause 11, wherein the macroscopic charged particle-optical element comprises around the beam paths a plurality of segments to which different electric potentials can be applied such that the macroscopic charged particle-optical element is configured to deflect the plurality of beams.
Clause 13: the electrostatic lens of clause 12, comprising at least four segments.
Clause 14: the electrostatic lens of any preceding clause, comprising:
   a focusing charged particle-optical element arranged such that an electric field between the upbeam charged particle-optical element and the focusing charged particle-optical element focuses each of the plurality of beams to a respective focus between the upbeam charged particle-optical element and the downbeam charged particle-optical element.
Clause 15: the electrostatic lens of clause 14, wherein the focus is substantially half way in a direction along the beam paths between the upbeam charged particle-optical element and the downbeam charged particle-optical element.
Clause 16: the electrostatic lens of clause 14 or 15, wherein a spacing in a direction along the beam paths between the upbeam charged particle-optical element and the focusing charged particle-optical element is smaller than a spacing in the direction along the beam paths between the macroscopic charged particle-optical element and either of the upbeam charged particle-optical element and the focusing charged particle-optical element.
Clause 17: the electrostatic lens of any of clauses 14 to 16, wherein the focusing charged particle-optical element is located between the upbeam charged particle-optical element and the macroscopic charged particle-optical element.
Clause 18: the electrostatic lens of any preceding clause, comprising:
   a conjugate charged particle-optical element arranged such that an electric field between the conjugate charged particle-optical element and the downbeam charged particle-optical element operates on each of the plurality of beams with a focal length less than an axial distance along the beam paths between the upbeam charged particle-optical element and the downbeam charged particle-optical element.
Clause 19: the electrostatic lens of clause 18, wherein the focal length is substantially half the axial distance between the upbeam charged particle-optical element and the downbeam charged particle-optical element.
Clause 20: the electrostatic lens of clause 18 or 19, wherein a spacing in a direction along the beam paths between the conjugate charged particle-optical element and the downbeam charged particle-optical element is smaller than a spacing in the direction along the beam paths between the macroscopic charged particle-optical element and either of the conjugate charged particle-optical element and the downbeam charged particle-optical element.
Clause 21: the electrostatic lens of any of clauses 18 to 20, wherein the conjugate charged particle-optical element is located between the macroscopic charged particle-optical element and the downbeam charged particle-optical element.
Clause 22: the electrostatic lens of any preceding clause, configured to reduce an angle by which the plurality of beams diverge from each other.
Clause 23: the electrostatic lens of clause 22, configured as a collimator lens for collimating the plurality of beams.
Clause 24: the electrostatic lens of any of clauses 1 to 21, configured to converge the plurality of beams to a focus.
Clause 25: the electrostatic lens of any preceding clause, comprising:
   spacers configured to space the upbeam charged particle-optical element, the macroscopic charged particle-optical element and the downbeam charged particle-optical element from each other.
Clause 26: the electrostatic lens of clause 25, wherein the upbeam charged particle-optical element, the macroscopic charged particle-optical element and the downbeam charged particle-optical element are secured to each other via the spacers.
Clause 27: a charged particle-optical device comprising the electrostatic lens of any preceding clause.
Clause 28: the charged particle-optical device of clause 27, comprising:
   a charged particle source configured to generate a divergent source beam from which the plurality of beams are derived.
Clause 29: the charged particle-optical device of clause 27 or 28, comprising:
   a condenser lens array configured to focus each of the plurality of beams on a focal plane, wherein the electrostatic lens is downbeam of the condenser lens array.
Clause 30: the charged particle-optical device of clause 29, wherein the condenser lens array is configured to derive the plurality of beams from the source beam.
Clause 31: the charged particle-optical device of clause 29, wherein the electrostatic lens is configured to derive the plurality of beams from the source beam.
Clause 32: the charged particle-optical device of any of clauses 29 to 31, wherein the electrostatic lens is located such that the macroscopic charged particle-optical element is substantially at the focal plane.
Clause 33: the charged particle-optical device of clause 32, wherein the electrostatic lens is located such that the macroscopic charged particle-optical element is upbeam of the focal plane.
Clause 34: the charged particle-optical device of clause, comprising:
   a controller configured to control application of electric potentials to the charged particle-optical elements of the electrostatic lens.
Clause 35: the charged particle-optical device of clause 34, wherein the controller is configured to control the electric potentials applied to the charged particle-optical elements of the electrostatic lens such that there is a potential difference between the macroscopic charged particle-optical element and each of the upbeam charged particle-optical element and the downbeam charged particle-optical element.
Clause 36: the charged particle-optical device of clause 35, wherein the controller is configured to control the potential difference dependent on a target change, by the electrostatic lens, of divergence between the beams.
Clause 37: the charged particle-optical device of any of clauses 34 to 36, wherein the controller is configured to control the electric potential applied to the upbeam charged particle-optical element to be substantially equal to the electric potential applied to the downbeam charged particle.
Clause 38: the charged particle-optical device of any of clauses 34 to 37, wherein the controller is configured to control the electric potentials applied to the upbeam charged particle-optical element and the downbeam charged particle-optical element such that a beam energy of charged particles of the beams entering the electrostatic lens is substantially equal to a beam energy of charged particles of the beams exiting the electrostatic lens.
Clause 39: the charged particle-optical device of any of clauses 27 to 38, comprising:
   at least one power source configured to apply at least one electric potential to at least one of the charged particle-optical elements of the electrostatic lens.
Clause 40: a method of manufacturing an electrostatic lens for a charged particle-optical device, the method comprising:
   forming in an upbeam charged particle-optical element a plurality of upbeam apertures for respective beams of the plurality of beams;
   securing the upbeam charged particle-optical element to a macroscopic charged particle-optical element in which is defined a macroscopic aperture for the plurality of beams;
   forming in a downbeam charged particle-optical element a plurality of downbeam apertures for respective beams of the plurality of beams; and
   securing the downbeam charged particle-optical element to the macroscopic charged particle-optical element, such that the macroscopic charged particle-optical element is located between the upbeam charged particle-optical element and the downbeam charged particle-optical element.
Clause 41: a method of collimating a plurality of beams of charged particles with an electrostatic lens, the method comprising:
   applying a potential difference between an upbeam charged particle-optical element, of the electrostatic lens, in which are defined a plurality of upbeam apertures for respective beams of the plurality of beams and a macroscopic charged particle-optical element, of the electrostatic lens, in which is defined a macroscopic aperture for the plurality of beams; and
   applying a potential difference between the macroscopic charged particle-optical element and a downbeam charged particle-optical element, of the electrostatic lens, in which are defined a plurality of downbeam apertures for respective beams of the plurality of beams;
   wherein the macroscopic charged particle-optical element is located between the upbeam charged particle-optical element and the downbeam charged particle-optical element.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. An electrostatic lens for a charged particle-optical device comprising:
an upbeam charged particle-optical element in which are defined a plurality of upbeam apertures for respective beams of a plurality of beams of charged particles;
a macroscopic charged particle-optical element in which is defined a macroscopic aperture for the plurality of beams; and
a downbeam charged particle-optical element in which are defined a plurality of downbeam apertures for respective beams of the plurality of beams;
wherein the macroscopic charged particle-optical element is located between the upbeam charged particle-optical element and the downbeam charged particle-optical element.

2. The electrostatic lens of claim 1, configured as an einzel lens.

3. The electrostatic lens of claim 1 or 2, wherein a thickness in a direction along the beam paths of the macroscopic charged particle-optical element is greater than a thickness in the direction along the beam paths of each of the upbeam charged particle-optical element and the downbeam charged particle-optical element.

4. The electrostatic lens of any preceding claim, wherein the macroscopic aperture is larger than the upbeam apertures and the downbeam apertures.

5. The electrostatic lens of any preceding claim, wherein a pitch between the upbeam apertures is different from a pitch between the downbeam apertures, or wherein the pitch between the upbeam apertures is smaller than the pitch between the downbeam apertures.

6. The electrostatic lens of any preceding claim, wherein a spacing in a direction along the beam paths between the upbeam charged particle-optical element and the macroscopic charged particle-optical element is greater than a dimension in a direction across the beam paths of each of the upbeam apertures, and/or wherein a spacing in a direction along the beam paths between the macroscopic charged particle-optical element and the downbeam charged particle-optical element is greater than a dimension in a direction across the beam paths of each of the downbeam apertures.

7. The electrostatic lens of any preceding claim, wherein a dimension in a direction across the beam paths of each of the upbeam apertures is smaller than a thickness in a direction along the beam paths of the upbeam charged particle-optical element, and/or wherein a dimension in a direction across the beam paths of each of the downbeam apertures is smaller than a thickness in a direction along the beam paths of the downbeam charged particle-optical element.

8. The electrostatic lens of any preceding claim, wherein the macroscopic charged particle-optical element is configured to deflect the plurality of beams.

9. The electrostatic lens of claim 8, wherein the macroscopic charged particle-optical element comprises around the beam paths a plurality of segments to which different electric potentials can be applied such that the macroscopic charged particle-optical element is configured to deflect the plurality of beams.

10. The electrostatic lens of claim 9, comprising at least four segments.

11. The electrostatic lens of any preceding claim, comprising:
a focusing charged particle-optical element arranged such that an electric field between the upbeam charged particle-optical element and the focusing charged particle-optical element focuses each of the plurality of beams to a respective focus between the upbeam charged particle-optical element and the downbeam charged particle-optical element.

12. The electrostatic lens of claim 11, wherein the focusing charged particle-optical element is located between the upbeam charged particle-optical element and the macroscopic charged particle-optical element.

13. The electrostatic lens of any preceding claim, comprising:
a conjugate charged particle-optical element arranged such that an electric field between the conjugate charged particle-optical element and the downbeam charged particle-optical element operates on each of the plurality of beams with a focal length less than an axial distance along the beam paths between the upbeam charged particle-optical element and the downbeam charged particle-optical element.

14. The electrostatic lens of any preceding claim, configured to reduce an angle by which the plurality of beams diverge from each other.

15. A charged particle-optical device comprising a charged particle source configured to generate a divergent source beam from which the plurality of beams are derived , and comprising the electrostatic lens of any preceding claim.
